# EUROPEAN PATENT SPECIFICATION

(11) **EP 3 113 221 B1**
(45) Date of publication and mention of the grant of the patent: **18.03.2020**
(21) Application number: 15174978.5
(22) Date of filing: 02.07.2015
(51) Int. Cl.: H01L 23/36, H01L 23/467, H01L 23/427, H05K 7/20, H01L 23/367

(54) **PASSIVE COOLING MODULE**
PASSIVES KÜHLMODUL
MODULE DE REFROIDISSEMENT PASSIF

(43) Date of publication of application: 04.01.2017
(73) Proprietor: Rohde & Schwarz GmbH & Co. KG, 81671 München (DE)
(72) Inventor: LASINGER, Martin, 82054 Sauerlach (DE); KRMPOTIC, Edwin, 85653 Aying (DE)
(74) Representative: Isarpatent

(56) References cited:
- EP-A1- 2 672 618
- DE-A1- 3 415 554
- DE-A1-102005 031 759
- GB-A- 2 520 108
- JP-A- 2005 264 834
- US-A- 3 277 346

## Description

The invention relates to a passive cooling module which can be assembled with other passive cooling modules to form a cooling structure.

Heat generating elements can generate during operation heat. Heat generating elements can comprise electronic components and/or electronic circuits comprising a plurality of electronic components which during operation consume electric power which is converted into heat. The heat generated during operation of the electronic components can be harmful to the electronic components, because an increased temperature can shorten the operation lifetime of an electronic component or an electronic system.

Heat sinks can be used to cool heat generating elements. A heat sink cools a heat generating element by absorbing and dissipating the generated heat. A heat sink can be made of a thermal conductive material and normally has a specific shape which improves the transfer of generated heat. In a conventional heat sink, the shape of the heat sink is formed such that it provides a great surface area. A heat sink can be designed to maximize its surface area surrounded by a cooling medium to increase the performance of the respective heat sink.

Conventional heat sinks are attached to the heat generating element and transfer thermal energy from the high temperature heat generating element to a lower temperature fluid medium. The shape and design of a conventional heat sink is adapted to the shape of the heat generating element to be cooled and the required heat transfer performance.

A conventional heat sink is attached to the heat generating element to be cooled by said heat sink, wherein the heat generating element is carried by a mechanical structure or printed circuit board. Conventional heat sinks do not allow to form a mechanical carrying structure which carries heat generating elements and is configured to cool the heat generating elements at the same time.

US 3 277 346 A relates to heat dissipation devices for electronic components.

DE 10 2005 031759 A1 relates to a cooling device comprising three metallic mold bodies arranged around a longitudinal axis, and a set of cooling surfaces formed with cooling units. DE 34 15 554 A1 relates to a heat sink for power electronic components that is made up of profiled strips.

EP 2 672 618 A1 relates to an arrangement for a modular inverter. The arrangement comprises a number of power semiconductors and cooling elements, the cooling elements being connected to the power semiconductors for cooling them, wherein the power semiconductors and the cooling elements are disposed around a centre axis of the arrangement in such a manner that they demark a channel around the centre axis in which a cooling medium is able to flow in the direction of the centre axis.

GB 2 520 108 A relates to a method and apparatus of cooling a heat source, comprising coupling a fin diffuser to a heat spreader to define a cooling assembly, and coupling the cooling assembly to the heat source and spreading heat from the heat source thereby cooling the heat source by using a centrifugal fan.

JP 2005 264834 A relates to a exhaust heat recovery equipment wherein a heat collecting fin of the exhaust heat recovery equipment generates electric power by a thermoelectric module by a temperature difference between exhaust gas and cooling water, and said fin is arranged on an end surface on the high temperature side of the thermoelectric module through an insulating material.

Accordingly, it is an object of the present invention to provide a heat sink element which can be used to build a mechanical structure which carries at least one heat generating el ement and which at the same time provides efficient cooling of the heat generating elements carried by the mechanical structure.

This object is achieved by a passive cooling module comprising the features of claim 1.

The invention provides according to a first aspect a passive cooling module having a shape adapted to be assembled with one or more passive cooling modules having a matching shape to form a cooling structure,
said passive cooling module comprising a base plate to receive heat from at least one heat generating element attached to said base plate,
wherein heat sink elements are connected to said base plate to transfer heat from said base plate to a surrounding fluid, wherein the heat sink elements extend perpendicular from said base plate and are enclosed by a metal plate and that the cooling module has a triangular shape, wherein, at least two heat spreading elements are attached to said base plate and the heat spreading element attached to said base plate of said passive cooling module is adapted to spread heat received from a heat generating element attached to said heat spreading element across said base plate of said passive cooling module to all heat sink elements.

The heat spreading element comprises a vacuum-sealed chamber filled with a liquid and said vacuum-sealed chamber is formed by water absorbed by a copper-mesh wick, wherein said water passes as vapour through a micro-perforated copper sheet where it cools and returns as liquid to the copper-mesh wick within said vacuum-sealed chamber.

In a further possible embodiment of the passive cooling module according to the first aspect of the present invention, said heat sink elements comprise heat sink fins.

In a still further possible embodiment of the passive cooling module according to the first aspect of the present invention, the fluid surrounding said heat sink elements is formed by air or water.

In a further possible embodiment of the passive cooling module according to the first aspect of the present invention, a thermally conductive pad is provided between the heat generating element and said heat spreading element.

In a further possible embodiment of the passive cooling module according to the first aspect of the present invention, the base plate, the heat sink elements and the metal plate are made of aluminium.

The invention further provides according to a further aspect a cooling structure comprising a plurality of passive cooling modules according to the first aspect of the present invention, wherein each cooling module carries at least one heat generating element.

In a possible embodiment of the cooling structure according to the second aspect of the present invention, the heat generating element comprises at least one electronic component.

In a further possible embodiment of the cooling structure according to the second aspect of the present invention, the heat generating elements carried by the passive cooling modules of said cooling structure are electrically connected to each other via electric cables.

In a further possible embodiment of the cooling structure according to the second aspect of the present invention, at least one fan is mounted to said cooling structure,
wherein said fan supplies air as a cooling fluid to the heat sink elements of passive cooling modules assembled within said cooling structure.

In the following, possible embodiments of the different aspects of the present invention are explained in more detail with reference to the enclosed figures.
- Fig. 1: shows a first possible embodiment of a passive cooling module according to the first aspect of the present invention;
- Fig. 2: shows a perspective view of the passive cooling module according to the first embodiment as illustrated in Fig. 1;
- Fig. 3: shows an exemplary embodiment of a passive cooling structure according to the second aspect of the present invention made of passive cooling modules as illustrated in Figs. 1 and 2;
- Fig. 4: shows a further exemplary passive cooling structure according to the second aspect of the present invention made of passive cooling modules as illustrated in Figs. 1 and 2;
- Fig. 5: shows a further exemplary cooling structure made of passive cooling modules as illustrated in Figs. 1 and 2;
- Fig. 6: shows a diagram for illustrating the operation of a passive cooling module according to a preferred embodiment;
- Fig. 7: shows a top view of a cooling structure made of four assembled passive cooling modules as illustrated in Figs. 1 and 2;
- Fig. 8: shows a top view of a further exemplary embodiment of a cooling structure made of six identical triangular passive cooling modules according to the first aspect of the present invention;
- Fig. 9: shows an exemplary complex cooling structure according to the second aspect of the present invention comprising a plurality of assembled passive cooling modules according to the first aspect of the present invention;
- Fig. 10: is not part of the invention and illustrates a passive cooling structure consisting of several L-shaped passive cooling modules according to the first aspect of the present invention;
- Fig. 11: is not part of the invention and illustrates cooling structure consisting of two complementary L-shaped passive cooling modules according to the first aspect of the present invention;
- Fig. 12: is not part of the invention and illustrates cooling structure comprising several rectangular passive cooling modules according to the first aspect of the present invention;
- Fig. 13: is not part of the invention and illustrates a passive cooling structure formed by a plurality of rectangular passive cooling modules according to the first aspect of the present invention;
- Fig. 14: is not part of the invention and illustrates a cooling structure comprising several hexagonal passive cooling modules according to the first aspect of the present invention.
- Fig. 15: shows a further exemplary embodiment of a cooling structure according to the second aspect of the present invention.

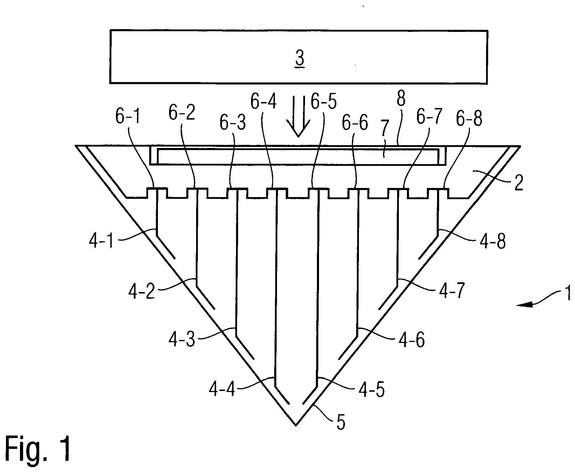

As can be seen in Fig. 1 illustrating an exemplary embodiment of a passive cooling module 1 according to the first aspect of the present invention the illustrated passive cooling module 1 has a shape adapted to be assembled with one or more further passive cooling modules having a matching shape to form a cooling structure according to the second aspect of the present invention. In the shown embodiment of Fig. 1, the passive cooling module 1 comprises a triangular shape. The illustrated passive cooling module 1 comprises a base plate 2 with at least one heat generating element 3 which is attached to the base plate 2. In a possible embodiment, a heat generating element 3 is fixed to said base plate 2 by mechanical fastening means comprising screws, bolts, etc. Alternatively, an adhesive can be used to fix the heat generating element 3 to the base plate 2. The base plate 2 is adapted to receive heat from the attached heat generating element 3. As can be seen in the embodiment of Fig. 1, heat sink elements 4-1, 4-2...4-n are connected to said base plate 2 to transfer heat from said base plate 2 to a surrounding fluid. In a possible embodiment, the heat sink elements 4-i comprise heat sink fins as shown in Fig. 1. The shown heat sink elements 4-i extend perpendicular from the base plate 2 as shown in Fig. 1. The heat sink elements 4-i vary in length and are enclosed by a metal plate 5 to provide a triangular shape of the passive cooling module 1. As shown in Fig. 1, the base plate 2 can comprise on one side several grooves for inserting the heat sink elements 4-i which can be soldered to the base plate 2 using a soldering agent. The number of heat sink elements 4-i can vary. In the illustrated embodiment of Fig. 1, the passive cooling module 1 comprises eight heat sink fins arranged in parallel to each other and attached to the base plate 2 by inserting the heat sink fins on one side into a corresponding groove 6-i and soldering the heat sink fins to said base plate 2. As shown in Fig. 1, each heat sink fin can be bent at the other end so that the surrounding metal plate 5 can be soldered to the heat sink fins 4-i. The parallel arranged heat sink fins 4-i as shown in the embodiment of Fig. 1 form fluid channels for a cooling fluid such as water, air or oil. The cooling fluid moving along the heat sink elements 4-i can receive thermal energy from the heat sink elements 4-i to cool the at least one heat generating element 3 attached to the base plate 2 of the passive cooling module 1.

A heat spreading element 7 is attached to the base plate 2. The heat spreading element 7 is adapted to spread heat received from the heat generating element 3 across the base plate 2 of the passive cooling module 1. In this way, the received heat is spread out by the heat spreading element 7 to all heat sink elements 4-i connected to the base plate 2. In a further possible embodiment, a thermally conductive pad 8 is provided between the heat generating element 3 and the heat spreading element 7.

The heat generating element 3 can comprise one or several electronic components mounted for instance on a printed circuit board which during operation consume electrical power and generate thermal energy. In a possible embodiment, the base plate 2, the heat sink elements 4-i and the surrounding metal plate 5 can be made of aluminium or aluminium alloys. In an alternative embodiment, other thermally conductive materials can be used such as copper or diamonds.

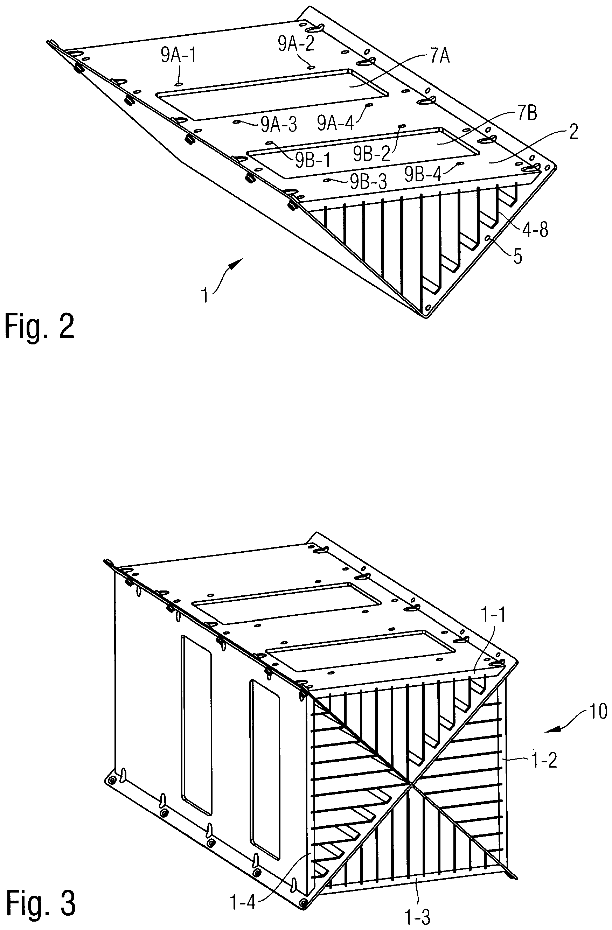

Fig. 2 shows a perspective view on the passive cooling module 1 as illustrated in Fig. 1. In the shown embodiment, the base plate 2 is formed to receive two heat spreading elements 7A, 7B, where two different heat generating elements can be attached to the base plate 2, for instance by screws. Fig. 2 shows receiving holes 9A-1 to 9A-4 for mounting a first heat generating element 3A to the base plate 2 by means of screws and receiving holes 9B-1 to 9B-4 for mounting a second heat generating element 3B to the second heat spreader 7B on the base plate 2. The number of heat spreading elements 7 inserted in or attached to the base plate 2 can vary.

Fig. 3 shows an exemplary embodiment of a cooling structure 10 according to the second aspect of the present invention comprising four passive cooling modules 1-1, 1-2, 1-3, 1-4 as shown in Fig. 2. The four passive cooling modules 1-1, 1-2, 1-3, 1-4 are connected to each other in a preferred embodiment by means of screws to form the passive cooling structure 10 as shown in Fig. 3. Since the passive cooling modules 1-i as shown in Figs. 1, 2 have a equilateral triangle shape, a square or quadratic passive cooling structure 10 consisting of four passive cooling modules 1-i is formed as shown in Fig. 3. The outer periphery of this passive cooling structure 10 is formed by the base plates 2-1, 2-2, 2-3, 2-4 of the passive cooling modules 1-1, 1-2, 1-3, 1-4, respectively. Accordingly, in the embodiment as illustrated in Fig. 3, the heat generating elements 3-i such as electronic circuits or electronic components can be attached to the outer periphery of the passive cooling structure 10 which carries the heat generating elements 3-i and cools the heat generating elements 3-i at the same time. In a possible embodiment, a fan can be mounted to the cooling structure 10 as shown in Fig. 3. The fan can supply a cooling fluid, in particular air, to the heat sink elements or heat sink fins of the passive cooling modules 1-i assembled within the cooling structure 10. In an alternative embodiment, if no fan is provided the cooling structure 10 as shown in Fig. 3 can be mounted such that the cooling fluid, i.e. air, passes along the heat sink elements 4-i vertically to improve convection. In a possible embodiment of the passive cooling structure 10 as shown in Fig. 3, different heat generating elements 3-i attached to the base plates 2-i via the heat spreading elements 7-i can be electrically connected to each other via electric or electronic cables. In this way, the cooling structure 10 can carry a plurality of complex or less complex electronic heat generating components 3-i which form a complex electronic circuit.

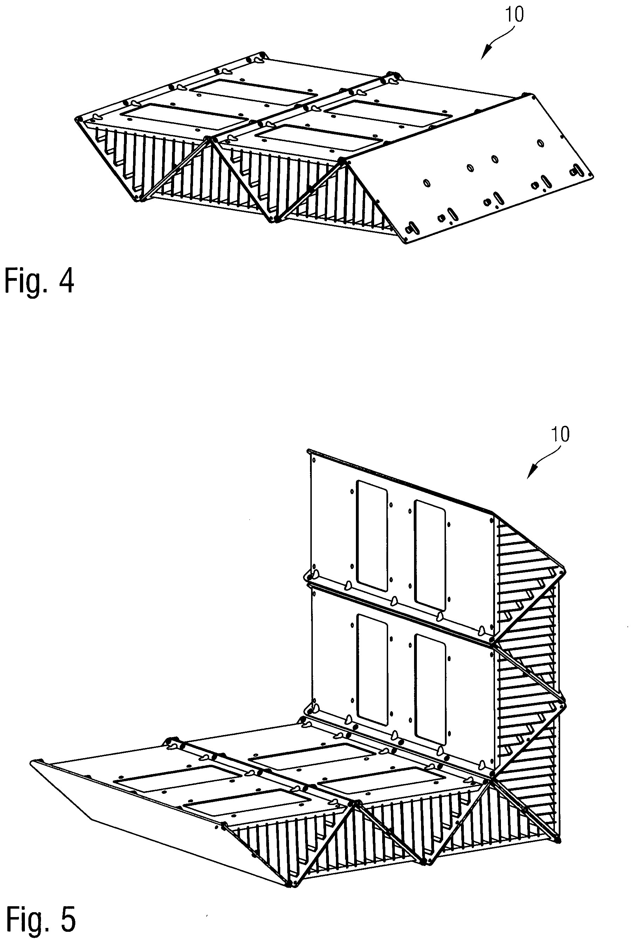

Fig. 4 shows a further exemplary embodiment of a passive cooling structure 10 made of four passive cooling modules 1-i as shown in Figs. 1, 2. As can be seen from Figs. 3, 4, the passive cooling structures 10 shown in Figs. 3, 4 use the same basic passive cooling modules 1-i but have a completely different structural form.

Fig. 5 shows a further exemplary cooling structure 10 made of passive cooling modules 1-i as shown in Figs. 1, 2. The cooling structure 10 illustrated in Fig. 5 comprises eight passive cooling modules 1-i and can be made of two cooling structures 10 as shown in Fig. 4. As can be seen from the exemplary embodiments shown in Figs. 3, 4, 5, by using the same passive cooling modules 1-i different cooling structures 10 of completely different form can be created. The form of the passive cooling structures 10 can be adapted to a specific surrounding or available place in a transporting container or casing of a machine.

In a possible embodiment of the passive cooling module 1 according to the first aspect of the present invention, the passive cooling module 1 comprises a heat spreading element 7 which has at least one vacuum-sealed chamber filled with a liquid. In a possible embodiment, the liquid is formed by water. In a possible embodiment, the liquid within the vacuum-sealed chamber of the heat spreading element 7 can be absorbed by a copper-mesh wick. In a possible embodiment, the heat spreader 7 comprises a copper encased two-phase vapour chamber into which pure water is vacuum-sealed. The water can be absorbed by a copper-mesh wick and passes as vapour through a micro-perforated copper sheet where it cools and returns as a liquid to the copper-mesh wick. As soon as external heat reaches the enclosed water, the water turns to steam or vapour passing through the micro-perforated copper sheet. The water moves through micro channels changing from water to vapour and back to water removing excess heat. The heat spreader 7 spreads the received heat across the base plate 2 of the passive cooling module 1 so that the heat reaches the heat sink elements 4-i attached to the base plate 2. The heat sink elements 4-i transfer the received heat to the cooling fluid such as air.

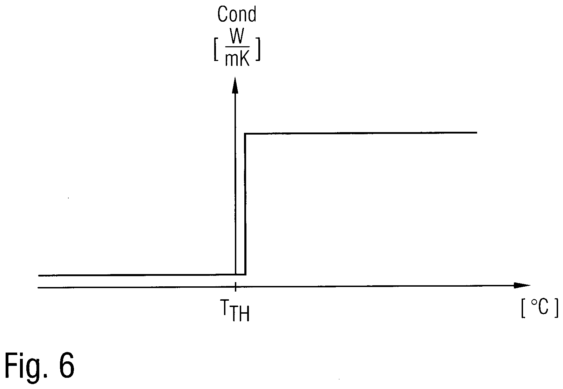

Fig. 6 shows a diagram illustrating the operation of a heat spreading element 7 comprising a vacuum-sealed chamber filled with water. The thermal conductivity of the heat spreading element 7 depends on the temperature T as illustrated in the diagram of Fig. 6. If the temperature T falls beneath 0°C, the water freezes and the thermal conductivity of the heat spreading element 7 becomes very low, i.e. almost zero. If the temperature T rises beyond 0°C, the frozen liquid, i.e. water, becomes fluid and the thermal conductivity of the heat spreading element 7 increases rapidly in a step function as shown in Fig. 6. Accordingly, when the passive cooling module 1 is used in a surrounding with very low temperatures under 0°C, the heat spreading element 7 has a very low thermal conductivity and isolates the heat generating element 3 from the base plate 2 of the passive cooling module 1. As the heat generating element 3 comprises electronic components, this has the significant advantage that the electronic components are not cooled by the passive cooling module 1 and no energy has to be wasted to warm up the heat generating electronic components 3 and to keep them in their regular operation temperature range.

In contrast, if the heat generating electronic components 3 operate in a surrounding temperature of more than 0°C, the thermal conductivity of the heat spreading element 7 is high as shown in Fig. 6 so that heat generated by the heat generating elements 3 is transported efficiently by the heat spreading element 7 and spread out across the base plate 2 of the passive cooling module 1 so that the heat generated by the heat generating components 3 is transferred efficiently to the heat sink elements 4-i. The threshold temperature T_{TH} of the diagram illustrated in Fig. 6 depends on the liquid filled within the vacuum-sealed chamber of the heat spreading element 7. In a possible embodiment, the threshold temperature T_{TH} is adapted to the operation temperature range of the heat generating element 3 attached to the passive cooling module 1. The size and width of the heat spreading element 7 can vary depending on the size of the base plate 2.

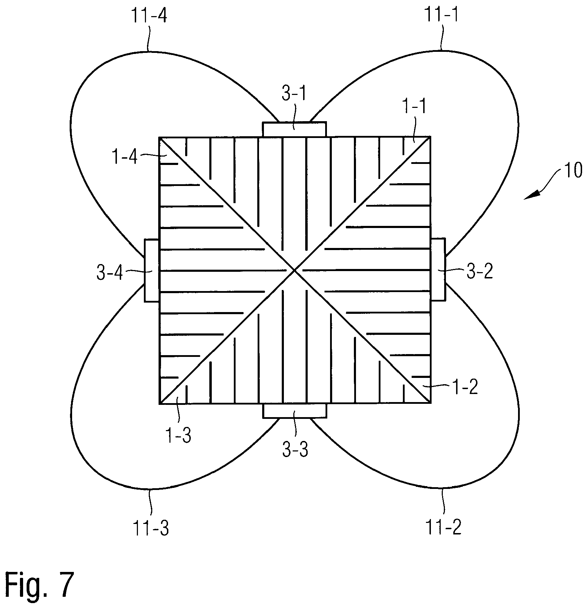

Fig. 7 shows a top view of a passive cooling structure 10 as shown in Fig. 3 consisting of four passive cooling modules 1-i as shown in the embodiment of Fig. 1, 2. In the shown embodiment, the cooling structure 10 carries four heat generating elements 3-1, 3-2, 3-3, 3-4 which can comprise one or several electronic components generating heat during operation. The electronic components 3-i are connected to each other via electronic cables 11-i as illustrated in Fig. 7. The different electronic components 3-i can form a complex electronic circuit cooled by the cooling structure 10 as shown in Fig. 7. Also channels between heat sink elements can be used for cabling.

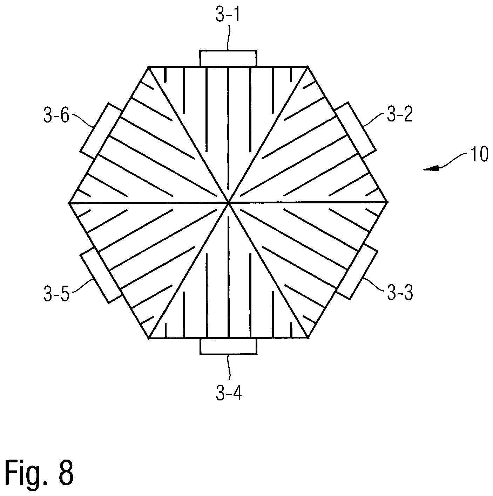

Fig. 8 shows a further exemplary passive cooling structure 10 made of six equilateral triangular passive cooling modules 1-i. In the shown embodiment, the cooling structure 10 carries six different heat generating elements 3-i.

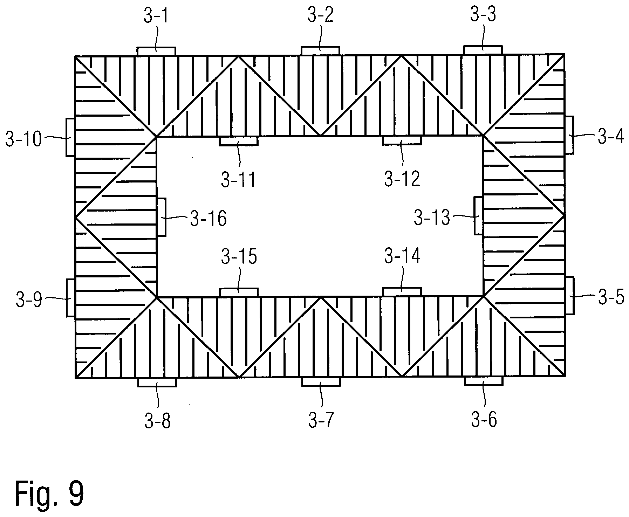

Fig. 9 shows a further more complex passive cooling structure 10 consisting of a plurality of triangular shaped passive cooling modules 1-i. The passive cooling structure 10 is a frame carrying ten heat generating elements 3-1 to 3-10 facing outwards and six heat generating elements 3-11 to 3-16 facing inwards. The different electronic heat generating components 3-i can perform different functions in a complex electronic circuitry. In the exemplary embodiment as shown in Fig. 9, the inward facing electronic components 3-i can be for instance very sensitive components which have to be protected against mechanical shock or vibrations and/or electromagnetic fields. Since the heat generating electronic elements 3-11 to 3-16 are surrounded by the passive cooling structure 10, they are automatically protected to some extent against mechanical damage or mechanical shocks. In contrast, the outer heat generating components 3-1 to 3-10 can be formed by less sensitive electronic components, in particular electromechanical components. In a further possible embodiment, the outer heat generating electronic elements 3-1 to 3-10 can be formed by elements having an interface function in the complex electronic circuit, whereas the inner heat generating electronic components 3-11 to 3-16 form core components of the complex circuit such as data processing elements. The different electronic components or heat generating elements 3-i as shown in Fig. 9 can be connected to each other via electric cables not illustrated in Fig. 9.

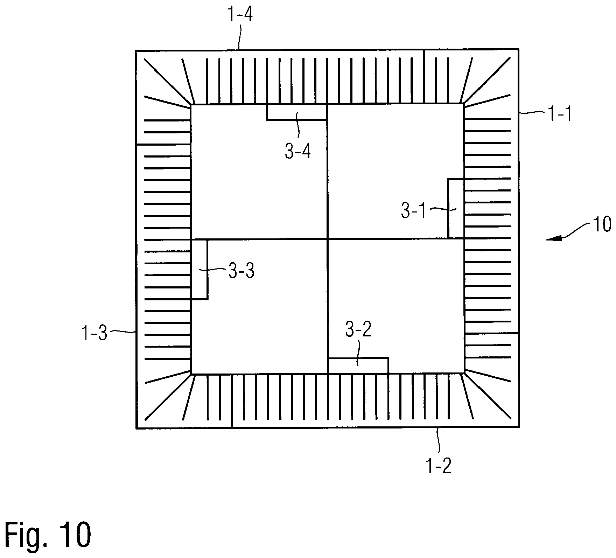

Fig. 10 illustrates a passive cooling structure 10 consisting of four L-shaped passive cooling modules 1-1, 1-2, 1-3, 1-4 each carrying a heat generating element 3-1, 3-2, 3-3, 3-4. The cooling structure 10 shown in Fig. 10 also forms a frame similar to the cooling structure shown in Fig. 9.

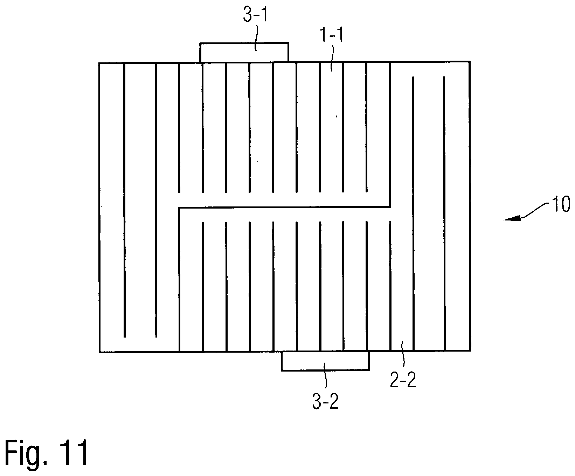

Fig. 11 illustrates a passive cooling structure 10 consisting of two complementary L-shaped passive cooling modules 1-1, 1-2 each carrying a heat generating element 3-1, 3-2.

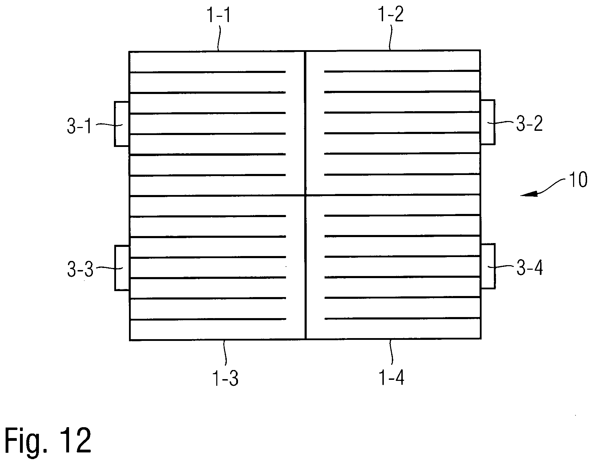

Fig. 12 illustrates a cooling structure consisting of four square passive cooling modules 1-1, 1-2, 1-3, 1-4 carrying four heat generating elements 3-1, 3-2, 3-3, 3-4.

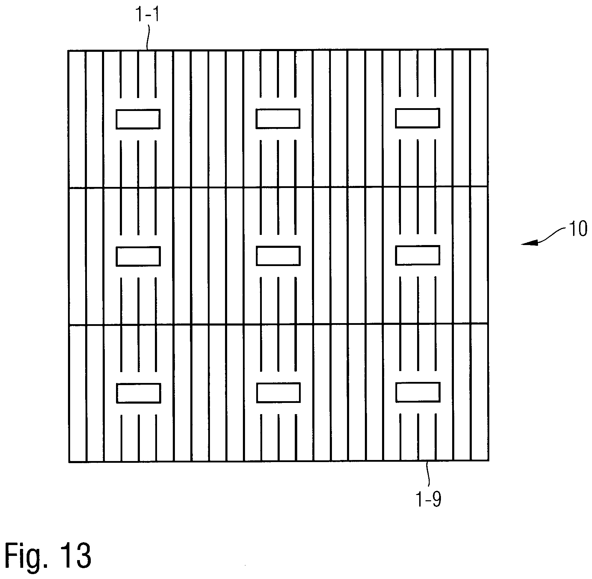

Fig. 13 illustrates a square passive cooling structure 10 consisting of nine identical square passive cooling modules 1-1 to 1-9, where each passive cooling module carries at least one heat generating element 3-i.

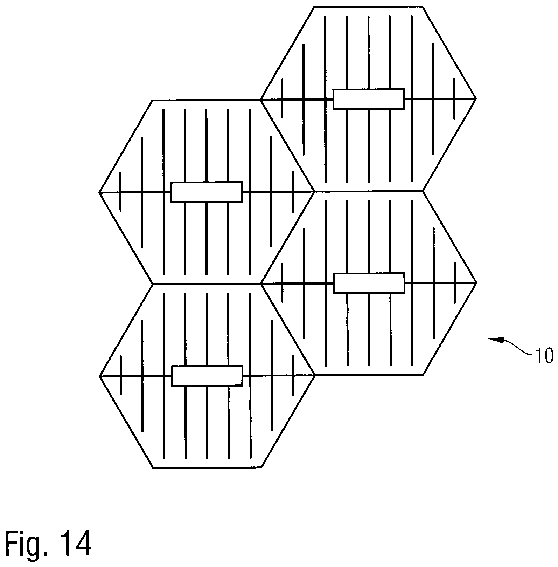

Fig. 14 illustrates a passive cooling structure 10 formed by four hexagonal passive cooling modules 1-i each carrying at least one heat generating element 3-i.

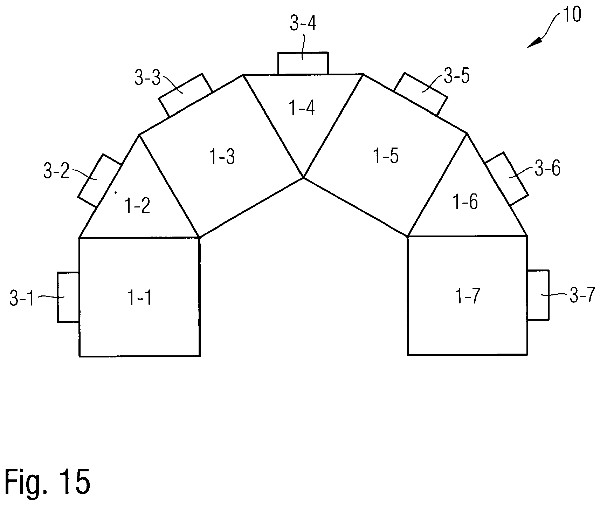

Fig. 15 shows a further exemplary embodiment of a passive cooling structure 10 consisting of several passive cooling modules 1-i of different matching shape. The passive cooling structure 10 forms an arc and comprises seven passive cooling modules 1-1, 1-2, 1-3, 1-4, 1-5, 1-6, 1-7. Each passive cooling module 1-i carries at least one heat generating element 3-i. In the shown embodiment, the passive cooling module 10 consists of passive cooling modules of different types. The first, third and fifth and seventh passive cooling modules 1-1, 1-3, 1-5, 1-7 within the arc-shaped passive cooling structure 10 are formed by square-shaped passive cooling modules, whereas the second, fourth and sixth passive cooling modules 1-2, 1-4, 1-6 are formed by triangular passive cooling modules. In the illustrated embodiment, the side length of the square-shaped passive cooling modules 1-1, 1-3, 1-5, 1-7 matches the side length of the triangular passive cooling modules 1-2, 1-4, 1-6 to form a compact structure. By connecting two passive cooling structures 10 as illustrated in Fig. 15, even a circular-shaped complex cooling structure can be created.

As can be seen from the wide variety of different cooling structures as illustrated in Figs. 7 to 15, with the passive cooling modules 1 according to the present invention, it is possible to construct cooling structures with very different forms and shapes in a modular way. The created cooling structure 10 can be specifically adapted to the respective use case. The created cooling structure 10 has a low weight and provides high mechanical resistance. The cooling structure 10 is formed by assembling a plurality of passive cooling modules 1 to each other and can carry a plurality of even heavy heat generating elements 3-i or of the components wherein it cools the heat generating elements 3-i at the same time very efficiently. The cooling structure 10 is also able to carry additional elements or devices such as cooling fans. Further, the cooling structure 10 allows to mount different types of heat generating elements or components 3-i to face outwards or to face inwards depending on the respective function and/or sensitivity of the mounted heat generating element 3-i. This increases flexibility in the design of a complex electronic circuit consisting of a plurality of heat generating components 3-i and allows to locate the heat generating elements or components according to their sensitivity and function at a proper place outside or inside a passive cooling structure frame 10. The cooling structure 10 can be adapted in its form to a surrounding carrying container or bag or to the available place within the casing of a complex machine. The passive cooling structure 10 can be scaled to the number of heat generating components 3 within the complex circuit. The passive cooling modules 1 used in the cooling structure 10 are mechanically robust and provide efficient cooling of the mounted heat generating components 3.

## Claims

1. A passive cooling module (1) having a shape adapted to be assembled with one or more passive cooling modules having a matching shape to form a cooling structure,
said passive cooling module (1) comprising a base plate (2) to receive heat from at least one heat generating element (3) attached to said base plate (2),
wherein heat sink elements (4) are connected to said base plate (2) to transfer heat from said base plate (2) to a surrounding fluid,
wherein the heat sink elements (4) extend perpendicular from said base plate (2) and are enclosed by a metal plate (5)and said passive cooling module (1) has a triangular shape,
**characterized in that**
at least two heat spreading elements (7) are attached to said base plate (2),
wherein said heat spreading element (7) is adapted to spread heat received from a heat generating element (3) attached to said heat spreading element (7) across said base plate (2) of said passive cooling module (1) to all heat sink elements (4),
wherein said heat spreading element (7) comprises a vacuum-sealed chamber filled with a liquid,
wherein said liquid within said vacuum sealed chamber is formed by water absorbed by a copper-mesh wick and passes as vapour through a micro-perforated copper sheet where it cools and returns as liquid to the copper-mesh wick within said vacuum sealed chamber.

2. The passive cooling module according to
claim 1, wherein said heat sink elements (4) comprise heat sink fins.

3. The passive cooling module according to claims 1 or 2,
wherein the fluid surrounding said heat sink elements (4) is formed by air or water.

4. The passive cooling module according to one of the preceding claims 1 to 3,
wherein a thermally conductive pad (8) is provided between the heat generating element (3) and said heat spreading element (7).

5. The passive cooling module according to one of the preceding claims 1 to 4, wherein said base plate (2), the heat sink elements (4) and the metal plate (5) of the passive cooling module are made of aluminium.

6. A cooling structure comprising a plurality of passive cooling modules according to one of the preceding claims 1 to 5, each carrying at least one heat generating element (3).

7. The cooling structure according to claim 6, wherein said heat generating element (3) comprises at least one electronic component.

8. The cooling structure according to claim 6 or 7, wherein the heat generating elements (3) carried by the passive cooling modules (1) of said cooling structure (10) are electrically connected to each other via electric cables.

9. The cooling structure according to one of the preceding claims 6 to 8, wherein at least one fan is mounted to said cooling structure (10),
wherein said fan supplies air as a cooling fluid to the heat sink elements (4) of passive cooling modules (1) assembled within said cooling structure (10).

## Patentansprüche

1. Passivkühlmodul (1), aufweisend eine Form, die ausgelegt ist, um mit einem oder mehreren Passivkühlmodulen, welche eine übereinstimmende Form aufweisen, zusammengesetzt zu werden, um eine Kühlstruktur zu bilden,
wobei das Passivkühlmodul (1) Folgendes umfasst:
eine Basisplatte (2), um Wärme von mindestens einem Wärmeerzeugungselement (3), das an der Basisplatte (2) angebracht ist, aufzunehmen,
wobei Wärmesenkelemente (4) mit der Basisplatte (2) verbunden sind, um Wärme von der Basisplatte (2) auf ein umgebendes Fluid zu übertragen,
wobei sich die Wärmesenkelemente (4) senkrecht von der Basisplatte (2) erstrecken und durch eine Metallplatte (5) eingeschlossen sind und das Passivkühlmodul (1) eine dreieckige Form aufweist,
**dadurch gekennzeichnet, dass**
mindestens zwei Wärmeverbreitungselemente (7) an der Basisplatte (2) angebracht sind,
wobei das Wärmeverbreitungselement (7) ausgelegt ist, um Wärme, die von einem Wärmeerzeugungselement (3) aufgenommen wird, das an dem Wärmeverbreitungselement (7) angebracht ist, über die Basisplatte (2) des Passivkühlmoduls (1) auf alle Wärmesenkelemente (4) zu verbreiten,
wobei das Wärmeverbreitungselement (7) eine mit einer Flüssigkeit gefüllte vakuumdichte Kammer umfasst,
wobei die Flüssigkeit innerhalb der vakuumdichten Kammer durch Wasser gebildet ist, das durch einen Kupfergeflecht-Docht absorbiert wird und als Dampf durch ein mikroperforiertes Kupferblech gelangt, wo es abkühlt, und als Flüssigkeit zu dem Kupfergeflecht-Docht innerhalb der vakuumdichten Kammer zurückkehrt.

2. Passivkühlmodul nach Anspruch 1, wobei die Wärmesenkelemente (4) Wärmesenken-Rippen umfassen.

3. Passivkühlmodul nach Anspruch 1 oder 2, wobei das Fluid, welches die Wärmesenkelemente (4) umgibt, durch Luft oder Wasser gebildet ist.

4. Passivkühlmodul nach einem der vorhergehenden Ansprüche 1 bis 3, wobei ein Wärmeleitfeld (8) zwischen dem Wärmeerzeugungselement (3) und dem Wärmeverbreitungselement (7) vorgesehen ist.

5. Passivkühlmodul nach einem der vorhergehenden Ansprüche 1 bis 4, wobei die Basisplatte (2), die Wärmesenkelemente (4) und die Metallplatte (5) des Passivkühlmoduls aus Aluminium sind.

6. Kühlstruktur, umfassend mehrere Passivkühlmodule nach einem der vorhergehenden Ansprüche 1 bis 5, die jeweils mindestens ein Wärmeerzeugungselement (3) tragen.

7. Kühlstruktur nach Anspruch 6, wobei das Wärmeerzeugungselement (3) mindestens eine elektronische Komponente umfasst.

8. Kühlstruktur nach Anspruch 6 oder 7, wobei die Wärmeerzeugungselemente (3), die durch die Passivkühlmodule (1) der Kühlstruktur (10) getragen sind, miteinander über elektrische Kabel elektrisch verbunden sind.

9. Kühlstruktur nach einem der vorhergehenden Ansprüche 6 bis 8, wobei mindestens ein Gebläse an der Kühlstruktur (10) montiert ist,
wobei das Gebläse den Wärmesenkelementen (4) von Passivkühlmodulen (1), die mit der Kühlstruktur (10) zusammengesetzt sind, Luft als Kühlfluid zuführt.

## Revendications

1. Module de refroidissement passif (1) ayant une forme adaptée pour être assemblé avec un ou plusieurs modules de refroidissement passif ayant une forme correspondante pour former une structure de refroidissement,
ledit module de refroidissement passif (1) comprenant une plaque de base (2) pour recevoir de la chaleur depuis au moins un élément de génération de chaleur (3) attaché à ladite plaque de base (2),
dans lequel des éléments dissipateurs de chaleur (4) sont raccordés à ladite plaque de base (2) pour transférer de la chaleur de ladite plaque de base (2) à un fluide environnant,
dans lequel les éléments dissipateurs de chaleur (4) s'étendent perpendiculairement à ladite plaque de base (2) et sont enserrés par une plaque métallique (5) et ledit module de refroidissement passif (1) présente une forme triangulaire,
**caractérisé en ce que**
au moins deux éléments de répartition de chaleur (7) sont attachés à ladite plaque de base (2),
dans lequel ledit élément de répartition de chaleur (7) est adapté pour répartir de la chaleur reçue depuis un élément de génération de chaleur (3) attaché audit élément de répartition de chaleur (7) en travers de ladite plaque de base (2) dudit module de refroidissement passif (1) vers tous les éléments dissipateurs de chaleur (4),
dans lequel ledit élément de répartition de chaleur (7) comprend une chambre sous vide remplie d'un liquide,
dans lequel ledit liquide au sein de ladite chambre sous vide est formé par de l'eau absorbée par une mèche à tressage en cuivre et passe sous forme de vapeur à travers une feuille de cuivre micro-perforée où il refroidit et revient sous forme liquide à la mèche à tressage en cuivre au sein de ladite chambre sous vide.

2. Module de refroidissement passif selon la revendication 1, dans lequel lesdits éléments dissipateurs de chaleur (4) comprennent des ailettes de dissipateur de chaleur.

3. Module de refroidissement passif selon la revendication 1 ou 2, dans lequel le fluide environnant lesdits éléments dissipateurs de chaleur (4) est formé par de l'air ou de l'eau.

4. Module de refroidissement passif selon l'une des revendications 1 à 3 précédentes,
dans lequel un socle thermiquement conducteur (8) est prévu entre l'élément de génération de chaleur (3) et ledit élément de répartition de chaleur (7).

5. Module de refroidissement passif selon l'une des revendications 1 à 4 précédentes, dans lequel ladite plaque de base (2), les éléments dissipateurs de chaleur (4) et la plaque métallique (5) du module de refroidissement passif sont constitués d'aluminium.

6. Structure de refroidissement comprenant une pluralité de modules de refroidissement passif selon l'une des revendications 1 à 5 précédentes, chacun portant au moins un élément de génération de chaleur (3).

7. Structure de refroidissement selon la revendication 6, dans laquelle ledit élément de génération de chaleur (3) comprend au moins un composant électronique.

8. Structure de refroidissement selon la revendication 6 ou 7, dans laquelle les éléments de génération de chaleur (3) portés par les modules de refroidissement passif (1) de ladite structure de refroidissement (10) sont connectés électriquement les uns aux autres par le biais de câbles électriques.

9. Structure de refroidissement selon l'une des revendications 6 à 8 précédentes, dans laquelle au moins un ventilateur est monté sur ladite structure de refroidissement (10),
dans laquelle ledit ventilateur fournit de l'air en tant que fluide de refroidissement aux éléments dissipateurs de chaleur (4) de modules de refroidissement passif (1) assemblés au sein de ladite structure de refroidissement (10).
